# EUROPEAN PATENT APPLICATION

(11) **EP 0 922 914 A2**
(43) Date of publication of application: **16.06.1999**
(21) Application number: 98830742.7
(22) Date of filing: 10.12.1998
(51) Int. Cl.: F24J 2/06, F24J 2/08

(54) **Optical system for utlizing solar energy**

(30) Priority: 12.12.1997 IT FI970272
(71) Applicant: CEO Centro di Eccellenza Optronica, 50125 Arcetri, Firenze (IT)
(72) Inventor: Longobardi, Giuseppe, 50125 Firenze (IT); Piattelli, Maurizio, 50125 Firenze (IT); Francini, Franco, 50124 Firenze (IT); Ciambellini, Claudio, 50144 Firenze (IT)
(74) Representative: Mannucci, Michele

(57) **Abstract**

The system comprises a collector of solar radiation and means of transferring and distributing the collected radiation to one or more user devices which may be relatively distant from each other. The collector comprises at least one optical concentrator and means of orientation for keeping the concentrator aimed at the sun; according to the invention, said transfer and distribution means comprise an optical fiber solar energy distribution system (3A, 3B, 3C, 7, 11A, 11B, 11C) for transferring the energy directly to said user devices.

## Description

The systems for collecting and using solar energy known at the present time are essentially based on two different systems, namely the use of photovoltaic panels and water-heating collectors.

In photovoltaic panel systems, the energy radiated by the sun is applied, directly or through an optical system, to solar cells which convert it directly into electrical energy, with the principal advantage of simple transport of the energy over a distance, but with low efficiency and poor utilization of the whole solar spectrum; moreover, these solar cells are expensive and have a limited life. The solar cells available at the present time have an efficiency of approximately 15% with respect to the solar energy radiated onto them, and furthermore their disposal, when they are spent, is extremely difficult. Moreover, in space applications, the solar cells are exposed directly to an unfavorable external environment.

Water-heating collector systems have a collector surface on which the solar radiation falls directly and which, becoming hot, transfers the heat by an exchange process to a fluid which is subsequently used for the storage and transport of the thermal energy. They have a high efficiency, due to the direct energy conversion, and relatively low cost, but the system of tubes for the circulation of the fluid, normally water, is expensive and difficult to install, and entails heat losses which limit the distance of the places of use from the collector. The circulation of the water in the installation also requires the use of pumps and energy. This type of collector is used principally for producing hot water for sanitary purposes and, to a lesser extent, for heating buildings and swimming pools, for drying (in agriculture), and less frequently for thermal cycles, for example for refrigeration. Recent design and engineering improvements have made it possible to achieve conversion efficiencies of approximately 40%, reduced to approximately 30% by the heat losses. Moreover, the irradiated surface is subjected to the external temperature, which has an effect on the efficiency of the collector.

Normally, not all the energy collected is used instantly, since both the requirements of the user and the collection of energy generally vary with time in an unrelated way. Use is therefore made of thermally insulated reservoirs, but these are expensive, and can only limit, rather than eliminate, the heat losses.

The primary object of the present invention is to eliminate or substantially reduce the disadvantages of the systems described above, particularly by using a system of transporting and switching the energy toward the places of use which is highly efficient and for which the purchase and installation costs are relatively low. This and other objects of the invention will be made clear by the following description.

The invention proposes a system for collecting and using solar energy, comprising at least one optical concentrator provided with means of orientation, to keep a constant orientation of the concentrator toward the sun, and means of transfer and distribution which comprise a light guide or flexible optical fiber cable for transferring the solar radiation from the focus of at least one of said concentrators directly to said user devices. In this way, the solar energy is carried without being converted and with minimal losses directly to the point of use, at which point it is either used in its existing state as light and radiant thermal energy or is converted into predominantly thermal or electrical energy. Thus the efficiency of the collection does not depend on the temperature of the external environment, and may reach values of the order of 70%, depending on the type of application.

Furthermore, the possibility of carrying solar energy through said flexible optical fiber cable directly to a multiplicity of points of use, such as water heaters, ovens, greenhouses, very high-efficiency concentrated photovoltaic generators, installations for health purposes and skin treatment, installations for industrial use of high-intensity light, illumination of rooms with light having the solar frequency spectrum, etc., permits a use of the energy which is more uniformly distributed over time, with less need to create heat reservoirs, providing savings in the costs of installation and energy losses. The optical concentrator also makes it possible to provide energy at a relatively high temperature, permitting uses, such as cooking food, which could otherwise not be envisaged with the hot-water collectors.

In a preferred embodiment of the invention, the collector comprises a plurality of modular elements, each comprising an optical concentrator, and the optical fiber distribution system comprises at least one adding device having a multiplicity of inputs and a single output. Each input is capable of receiving through an optical fiber solar energy from the focus of each modular element of the collector. In this way the adding device can be used to add the amounts of energy received from the various modular elements of the collector, so that they can be sent along a single optical fiber through said output toward the user.

The system may also comprise at least one switching device having an input connected to the output of the adding device by an optical fiber, to receive the collected solar energy, and a multiplicity of outputs, each of which is capable of sending light energy to a corresponding user device through a corresponding optical fiber. By changing the setting of the switch, it is possible to direct the solar energy to one or more outputs, thus enabling the energy use to be distributed according to necessity and availability.

In a first embodiment of the invention, said concentrator may comprise an optical refracting system and/or a minor system. Said optical refracting system may comprise a Fresnel lens with spherical segments exposed directly to the solar radiation and concentrating the radiant flow received on one end of an optical fiber.

Means of orientating the collector are provided, and may comprise a gimbal mounting of the collector, of each line of modular elements or of each modular element of the collector, and means controlled by an aiming system to follow the apparent motion of the sun and always expose the surface of the modular elements orthogonally to the sun.

In another embodiment of the invention, the optical refracting system may comprise a first Fresnel lens with parallel cylindrical segments and a second Fresnel lens extending in a dimension parallel to the axis of the cylindrical segments of said first lens; the optical axes of said two lenses are orthogonal to each other, and a mirror is interposed between said lenses to direct the solar flow from the first to the second lens, the flow being finally concentrated at the end of an optical fiber. The mirror is rotatable about an axis parallel to the axis of said cylindrical elements to follow the movements of the sun orthogonal to the mirror's axis of rotation, for example in order to compensate for the seasonal variations of the apparent path of the sun. The concentrator thus has a limited axial dimension, and requires, for orientation, the possibility of rotating the axis of each modular element solely about an axis parallel to the Earth's axis, to compensate for the apparent hourly movements of the sun.

A further embodiment of the invention provides for the use of a mirror which can be orientated in two axes, and is interposed between the optical system and the transport system.

Further advantageous characteristics and embodiments of the system according to the invention are specified in the attached claims.

The invention will be more clearly understood from the description and the attached drawing, which shows a non-restrictive practical embodiment of the invention. In the drawing,
Fig. 1 is a schematic view of an installation for collecting and utilizing solar energy according to the invention;
Figs. 2 and 3 are schematic perspective views of the optical system of a collector according to two embodiments of the invention;
Figs. 4, 5 and 6 are schematic perspective views of three different embodiments of collectors according to the invention; and
Figs. 7, 8, 9 and 10 are schematic perspective views of appliances using the energy collected by a system according to the invention.

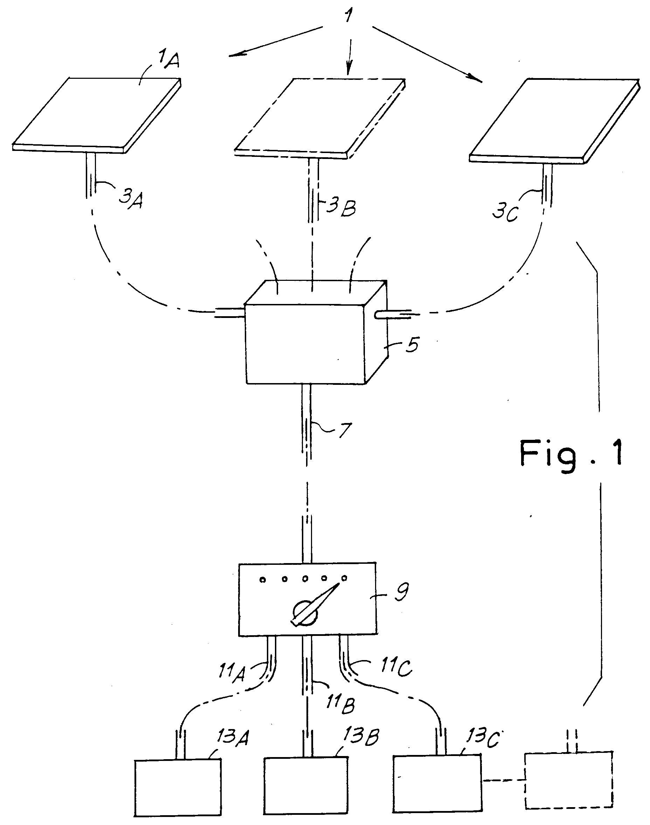

In the remainder of this document, the term "optical fiber" denotes either a single fiber or a bundle of optical fibers. With reference to Fig. 1, the system comprises a collector 1 formed by a plurality of modular elements 1A; these elements may be brought together in various ways. Each modular element presents a square surface with a side measurement of 30 cm to the solar radiation, and can therefore collect, at southern European latitudes, up to 90 W of solar energy. It will be clear from the following description of the configuration of said modular elements that the solar energy collected by each element at the output of the element is directed by means of a corresponding optical fiber 3A, 3B, 3C, etc. into an adding device 5 on which the optical fibers of all the elements of the collector 1 converge. The solar energy collected by the various modular elements is directed from the adding device 5, which is conveniently located near the collector 1, through a single output optical fiber 7 to a switching device 9, from which it can be sent by means of corresponding optical fibers 11A, 11B, 11C, etc. to one or more user devices 13A, 13B, 13C, etc. The user devices may use the energy in the form in which it is received, for example for lighting or radiant heating, or may convert it into another form, for example into electrical or thermal energy, possibly for transmission to remote users.

In the described system, the optical fibers are of the type having low absorption losses over a wide range of frequencies of the solar spectrum, for example fibers made from silica with a low content of impurities - for good transmission in the infrared - which may be enriched with hydroxyl groups, OH, for low absorption in the ultraviolet range. Preferably, the fibers will also be of the type with a high numerical aperture (NA), in other words of the type which accepts at the input rays with a large angle of incidence, for example 30°, or preferably 40°, thus making it possible to reduce the focal length and the overall dimensions of the optical concentrator.

The optical fibers running from the individual elements of the collector are physically and optically connected, at their ends furthest from said elements, to an adding device 5 which enables the solar radiation transmitted by each fiber 3A, 3B, 3C to be transferred to a single optical fiber 7 which runs from the device.

This single fiber 7 terminates in a switching device 9 after having passed through the building, from the adding device which is preferably located near the collector (and therefore usually on the roof of the building) to a switching station within the building. The switch 9 comprises means capable of switching the path of the solar energy captured by the collector, and arriving through the fiber 7, between one or more fibers 11A, 11B, 11C, etc. running from the switch, each of these fibers being connected to a different user device 13A, 13B, 13C, etc.

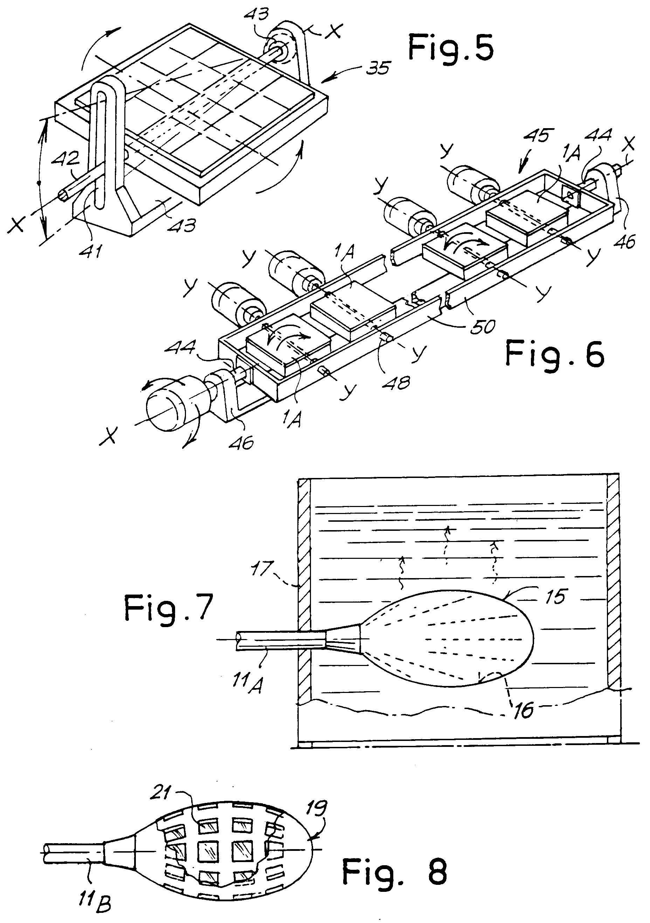

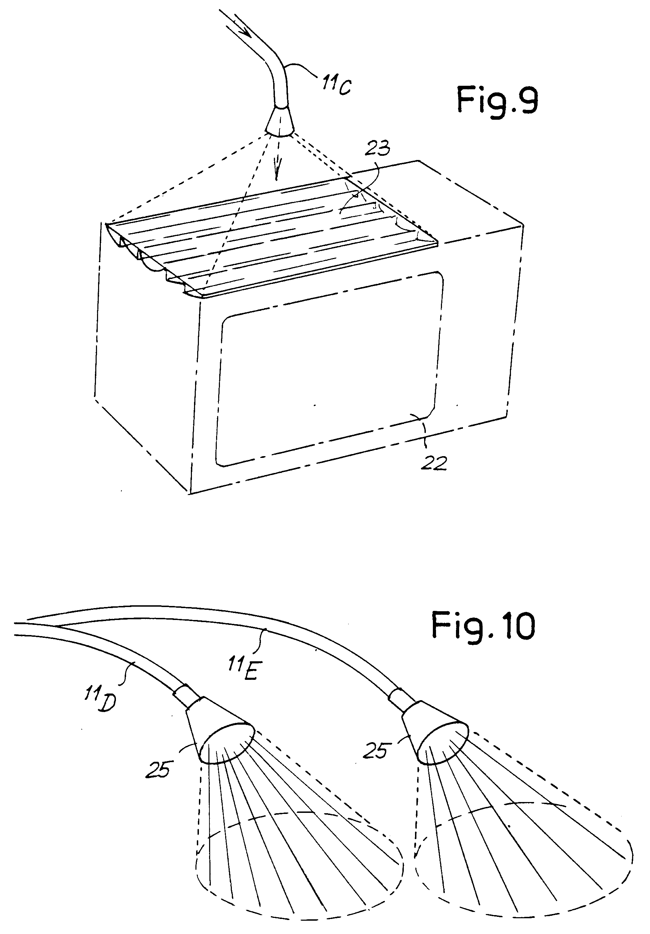

Said user devices may be:
- a water heater (Fig. 7), comprising a metal body 15 having a cavity 16 whose surface is treated to make it absorbent. A fiber 11A is inserted in a hole of the body 15 and opens into said cavity; in this way, the cavity 16 receives radiant solar energy which heats the metal body 15. The body 15 is immersed in a tank 17 full of water and converts the radiant solar energy received, transferring it to the water in the form of thermal energy;
- a generator of electrical energy (Fig. 8), in which photovoltaic cells 19 are arranged facing each other on the surface 21 of a cavity, with a fiber 11B directing radiant solar energy into said cavity;
- a chamber 22 (Fig. 9) which, depending on its size, may act as a greenhouse or as an oven for heating objects or for cooking food, the top of the chamber consisting of a Fresnel lens 23. The end of a fiber 11C, capable of projecting onto the lens the solar energy received from a collector as described above, is located above the lens at its focus. In this case, the lens acts as a diffuser for illuminating and/or heating the chamber in a uniform way;
- light-dispersing lighting appliances 25 (Fig. 10), each being connected mechanically and optically to the end of a corresponding optical fiber 11D, 11E running from said switch 9, to disperse solar energy in front of it. These appliances could consist of tubular polycarbonate modules with minor-smooth internal surfaces and external surfaces having a microstructure in the form of regular prisms, for example the modules called "Linea di luce" marketed by the 3M-Italia company. With these modules it is a simple matter to construct a linear lighting system whose length is variable in a modular way.

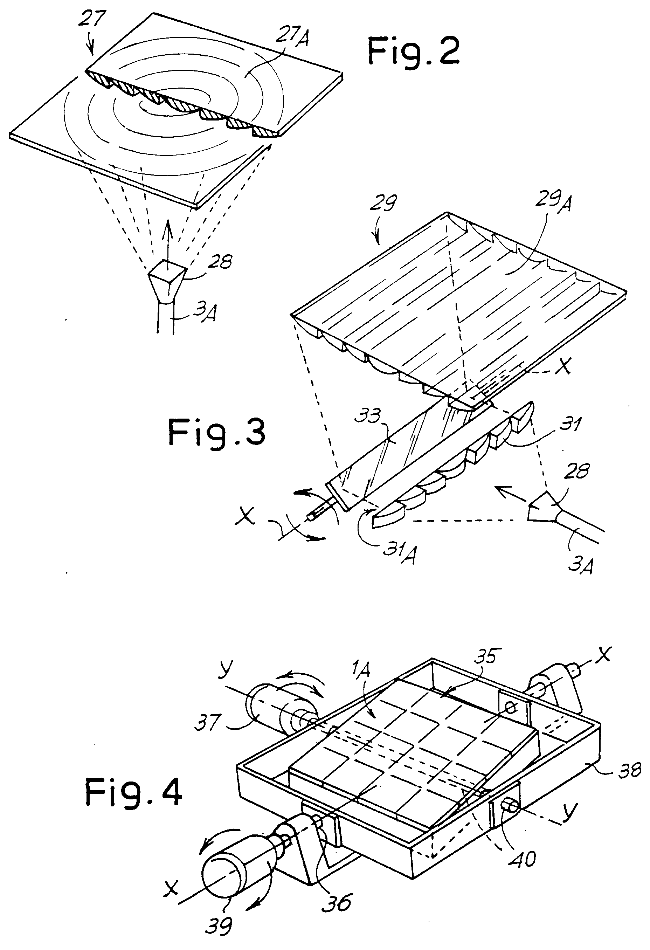

In a first embodiment of the invention, the solar collector 1 is formed by a multiplicity of modular elements 1A in which the surface directly illuminated by the sun is the flat surface 27A (Fig. 2) of a Fresnel lens 27 with toric elements, said surface being orientated toward the sun. The lens 27 concentrates the received solar energy on the larger base of an optical body 28 in the form of a truncated pyramid fitted to one end of an optical fiber 3A in such a way that it directs into it the solar radiation collected by the lens 27.

In another embodiment of the invention, in each modular element the surface directly illuminated by the sun is the flat surface 29A (Fig. 3) of a Fresnel lens 29 with cylindrical elements, said surface being orientated toward the sun. The lens 27, with the interposition of a rectangular mirror 33, concentrates the solar energy received by the lens on the flat side 31A of a second Fresnel lens 31, said second lens 31 extending essentially in a direction parallel to the axis of the cylindrical elements of the first lens 27 to concentrate the received solar energy on the larger base of an optical body 28 in the form of a truncated pyramid fitted to one end of an optical fiber 3A in such a way that it directs into it the solar radiation collected by the lens 29. The Fresnel lenses 27, 31 have optical axes orthogonal to each other and a mirror 33 is interposed between them to direct the solar energy flow from the first to the second lens.

In the solar collector, said modular elements may be joined like tiles to form a panel 35 (Figs. 4, 5) extending in a plane or a panel 45 (Fig. 6) extending in a single line of tiles.

Means of automatic orientation of the panel are provided and comprise an optical aiming device of the photocell type and a control unit, these not being shown in the drawing, the control unit being capable of orientating the collector by means of servo motors 37, 39 (Fig. 4) in two axes X-X, Y-Y which are orthogonal to each other. This may be achieved either by using a true gimbal mounting 36, 38, 40 of the collector (Fig. 4), or one in which (Fig. 5) one of the rotations, for example that used to follow the seasonal variations of the plane of the ecliptic, is obtained by moving one of the hinging points of pins 42 defining an axis X-X along a slot 41 of the support 43 of the collector, the other hinging point being a ball joint 43. Alternatively, the collector 45 (Fig. 6) comprises a cradle support 50 for a line of modular elements 1A located next to each other; the support 50 can be rotated by means of pins 44 hinged to a fixed support 46 and defining an axis X-X. Each modular element 1A of the collector is hinged, by corresponding pins 48 defining an axis Y-Y orthogonal to said axis X-X of rotation of the collector, to the cradle support 50, and can be rotated by means of a mechanical transmission and a servo motor. Alternatively, in the case of a modular element 1A shaped as shown in Fig. 3, the mirror 33 may be hinged with respect to the support of the lenses 29, 31, and orientated by means of said control unit and a servo motor to keep the solar energy flow leaving the lens 29 concentrated on the lens 31, thus compensating for said seasonal variation of the apparent path of the sun.

It is to be understood that the drawing shows only an example provided solely as a practical demonstration of the invention, and that this invention may be varied in its forms and dispositions without departure from the guiding concept of the invention. The presence of any reference numbers in the attached claims has the purpose of facilitating the reading of the claims with reference to the description and to the drawing, and does not limit the scope of protection represented by the claims.

## Claims

1. A system for collecting, transporting and utilizing solar radiation, comprising a collector which collects the solar energy radiated on to it, and means of transferring and distributing the collected energy to one or more user devices which may be relatively distant from each other, characterized in that said collector comprises at least one optical concentrator (27; 29, 31) and means of orientation (37, 39) for keeping a constant orientation of the optical concentrator toward the sun, and in that said transfer and distribution means comprise an optical fiber solar energy distribution system (3A, 3B, 3C, 7, 11A, 11B, 11C) for transferring the energy from the focus of said at least one concentrator directly to said user devices.

2. The system as claimed in claim 1, characterized in that said collector comprises a plurality of modular elements (1A), each comprising an optical concentrator (27; 29, 31).

3. The system as claimed in claim 2, characterized in that the optical fiber distribution system (3A, 3B, 3C, 7, 11A, 11B, 11C) comprises at least one adding device (5) having a multiplicity of inputs and one output, each input being capable of receiving through an optical fiber (3A, 3B, 3C) solar energy from the focus of each modular element (1A) of the collector, the adding device enabling the amounts of energy received from the various inputs to be added together so that they can be sent toward the user along an optical fiber (7) through said output.

4. The system as claimed in claim 2 or 3, characterized in that said optical fiber distribution system (3A, 3B, 3C, 7, 11A, 11B, 11C) comprises at least one switching device (9) having one input connected to an optical fiber (7) to receive light energy and a multiplicity of outputs, each capable of sending light energy through a corresponding optical fiber (11A, 11B, 11C) to a corresponding user device.

5. The system as claimed in any of the preceding claims, characterized in that said at least one concentrator (27) comprises optical refracting elements.

6. The system as claimed in any of the preceding claims, characterized in that said at least one concentrator (27) comprises optical mirror elements.

7. The system as claimed in claim 5 or 6, characterized in that at least one of said refracting elements is a Fresnel lens (27A) with toric segments.

8. The system as claimed in claim 5 or 6, characterized in that it comprises a first Fresnel lens (29) with cylindrical segments extending substantially in two dimensions and a second Fresnel lens (31) extending substantially in a dimension parallel to the axis of the cylindrical segments of said first lens, the optical axes of the lenses (29, 31) being orthogonal to each other, and a mirror (33) interposed between said lenses and rotatable about an axis parallel to the axis of said cylindrical segments to follow the movements of the sun which are orthogonal to its axis of rotation.

9. The system as claimed in any of the preceding claims, characterized in that the means of orientating the collector comprise a gimbal mounting (36, 38, 40) of the collector (35) or of each element (1A) of the collector.

10. The system as claimed in claim 9, characterized in that said orientating means comprise the fact that the modular elements (1A) of the collector are located next to each other in parallel lines to form a matrix (45) and that the elements of each line are carried by a single cradle support (50) rotatable by means of hinges (44) about an axis (X-X) parallel to the extension of the line, each element (1A) of the line being hinged to said cradle support (50) by means of a corresponding shaft (48) defining an axis (Y-Y) orthogonal to said axis (X-X) of the support, to complete said gimbal mounting.

11. The system as claimed in any of the preceding claims, characterized in that at least one of said devices for utilizing solar energy comprises a black body (15) contacted by a fluid, the black body being arranged so that it receives solar energy through a corresponding branch (11A) of said optical fiber distribution system and transmits it to said fluid in the form of heat.

12. The system as claimed in claim 11, in which said black body (15) is hollow and contacted externally by said fluid, the interior of the cavity receiving solar energy through said branch (11A) of said optical fiber distribution system.

13. The system as claimed in any of the preceding claims, characterized in that at least one of said devices for utilizing solar energy comprises an array (21) of photovoltaic cells (19) receiving solar energy through a corresponding branch (11B) of said optical fiber distribution system, to convert it into electrical energy.

14. The system as claimed in any of the preceding claims, characterized in that at least one of said devices for utilizing solar energy comprises a cavity (22) illuminated by means of an illuminating lens (23) which receives solar energy through a corresponding branch (11C) of said optical fiber distribution system, in such a way as to form a furnace or a greenhouse.

15. The system as claimed in any of the preceding claims, characterized in that at least one of said devices for utilizing solar energy comprises at least one light disperser (25) which receives solar energy through a corresponding branch (11D, 11E) of said optical fiber distribution system, to illuminate the environment in which the device is located.

16. A system for collecting and utilizing solar energy, the whole as described above and as represented by way of example in the attached drawing.
